# EUROPEAN PATENT APPLICATION

(11) **EP 1 467 376 A2**
(43) Date of publication of application: **13.10.2004**
(21) Application number: 04252124.5
(22) Date of filing: 08.04.2004
(51) Int. Cl.: G11C 11/16, G11C 11/22, H01L 27/115, H01L 27/22

(54) **Memory cell, memory device and manufacturing method of memory cell**

(30) Priority: 11.04.2003 JP 2003108021
(71) Applicant: SHARP KABUSHIKI KAISHA, Osaka 545-8522 (JP)
(72) Inventor: Morimoto, Hidenori, Kashihara-shi, Nara 634-0077 (JP)
(74) Representative: Brown, Kenneth Richard

(57) **Abstract**

A memory cell (33) in which a variable resistive element (31) and a Schottky diode (32) are connected in series to each other. In a memory device, bit lines (BL0, BL1 and BL2) are arranged in a column direction, one end of the bit line (BL) is connected to a bit line decoder (34), and the other end thereof is connected to a reading circuit (37). Word lines (WL0, WL1 and WL2) are arranged in a row direction so as to intersect with the bit lines (BL), and both ends of the word line (WL) are connected to word line decoders (35 and 36). In other words, the bit line (BL) and the word line (WL) are arranged in a matrix and a memory cell (33) is located at a position where the bit line (BL) and the word line (WL) intersect with each other, which constitutes the memory device. An influence of a reading disturbance in the memory cell (33) and the memory device is reduced.

## Description

### BACKGROUND OF THE INVENTION

### 1. Field of the Invention

The present invention relates to a 1D1R-type (a unit cell is constituted by one diode and one variable resistive element) of memory cell constituted by a series circuit of a variable resistive element and a Schottky diode, a memory device in which such memory cells are arranged in a matrix, and a manufacturing method of such memory cell.

### 2. Description of Related Art

Many of MRAMs (Magnetic Random Access Memories) which recently have been developed employ a method in which a ferromagnetic memory cell for storing information by residual magnetism of a ferromagnetic material of colossal magneto resistive material is constituted, and the stored information is read by converting a variation of an electric resistance value generated by a difference between directions of magnetization, to a voltage. A metal wiring for writing is provided in the ferromagnetic memory cell, and the direction of magnetization of the ferromagnetic memory cell is changed in a magnetic field generated when a current of milliampere-order is flowed to the metal wiring for writing, whereby information is written or rewritten in the ferromagnetic memory cell.

In the MRAM (that is, the ferromagnetic memory cell), since it is necessary to flow a large current (milliampere-order) at the time of writing, the wiring for writing is formed of metal. As an example of such MRAM, 1T1R type (a unit cell is constituted by one transistor and one magneto resistive element) of MRAM is known, in which a pair of wirings intersecting with each other serves as both writing and reading lines, and a field effect transistor for selecting a cell and a magneto resistive element containing a colossal magneto resistive thin film are combined (see Japanese Patent Application Laid-Open No. 6-84347 (1994), for example). Such memory cell containing the colossal magneto resistive thin film exhibits a magneto resistive effect in which the electric resistance value varies depending on the direction of magnetization.

Furthermore, W. J. Gallagher et. al. in IBM Ltd. have disclosed a memory array (memory device) in which a 1D1R type (a unit cell is constituted by one diode and one magneto resistive element) of MRAM comprising one magneto resistive element and one diode formed by one PN junction which are connected in series to each other is connected by X-Y wiring provided in a matrix (see U.S. Patent No. 5,640,343). According to this technique, a devious current generated in a structure in which the magneto resistive element is sandwiched by the simple matrix wirings can be avoided by the diode and, since the structure is simple as compared with the 1T1R type, there is a possibility that an area of the memory cell can be reduced. In a memory array in which a unit memory cell comprising one tunnel magneto resistive element (TMR element) and one diode formed by the PN junction are connected in series to each other is connected by X-Y wirings provided in a matrix, since a large magneto resistive ratio is required in order to prevent an influence of fluctuation of a resistance value of the TMR element, fluctuation of forward resistance of the diode, voltage drop of the wiring and the like, it is difficult to constitute a memory chip.

According to a manufacturing method disclosed in U.S. Patent No. 5,640,343, since a process for forming the diode is executed after forming one metal wiring of the X-Y wirings, polycrystalline silicon comprising a p-type impurity and polycrystalline silicon comprising n-type impurity are joined to form the diode. In view of melting and deterioration of the metal wiring affected by a heat treatment at forming the diode, there is a problem in that high-temperature heating process cannot be adopted when the diode is formed. As a result, since characteristics of the diode deteriorate and a leak current at the time of reverse bias is increased, it is difficult to constitute a large-scale memory array. In other words, although it is advantageous in an integration degree because a cell area is small in the MRAM arranged in a matrix, it is difficult to realize an element constitution and driving method which can correspond to high integration.

As a variable resistive element having a resistance variation rate higher than that of the magneto resistive element in the above-described MRAM, a material having a perovskite-type crystalline structure, a double aligned perovskite-type crystalline structure or the like which exhibits colossal magneto resistive or high temperature super conductivity such as Pr₍₁₋ₓ₎CaₓMnO₃ (0 < x < 1), La₍₁₋ₓ)CaₓMnO₃ (0 < x < 1), Nd₍₁₋ₓ₎SrₓMnO₃ (0 < x < 1), Sr₂FeMoO₆, Sr₂FeWO₆ or the like is known (see U.S. Patent No. 6,204,139). When such variable resistive element is used, the above-described problem can be solved.

In U.S. Patent No. 6,204,139, there has been proposed a method in which one or more short electric pulses are applied to a thin film or a bulk formed of a thin film material having the perovskite structure, especially a colossal magneto resistive material and a high temperature super conductivity material, to change its electrical characteristics. An electric field strength and a current density caused by the electric pulse at this time can be low enough to change the physical condition of the material and not to destroy the material, and the electric pulse may be either positive or negative polarity. The material characteristics can be further changed by repeatedly applying the plural electric pulses to the above variable resistive element. FIG. 1 through FIG. 4 show characteristics of the variable resistive element disclosed in U.S. Patent No. 6,204,139.

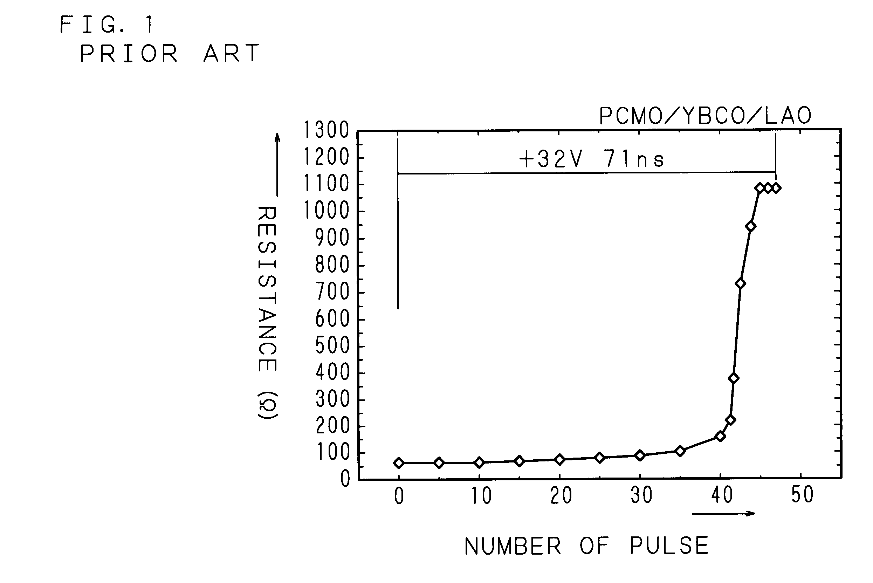

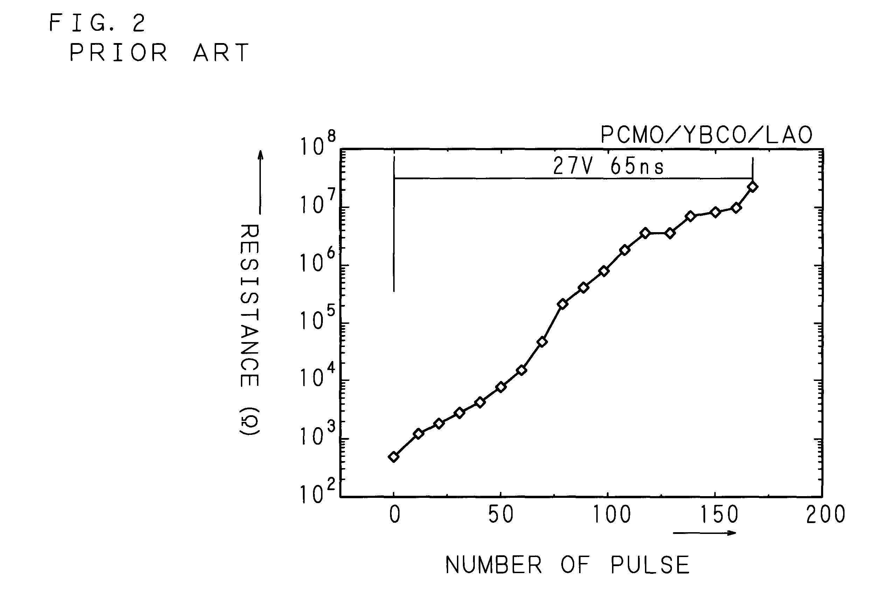

FIG. 1 and FIG. 2 are graphs schematically showing a relation between the number of applied pulses and a resistance value in the above variable resistive element. FIG. 1 shows a relation between the number of pulses applied to a CMR film grown on a metallic substrate and a resistance value. In the example shown in FIG. 1, pulses up to 47 each having an amplitude of +32 V and a pulse width of 71 ns are applied. Under such condition, as can be seen from the characteristics shown in FIG. 1, the resistance value changes in a range of about one digit as the number of applied pulses is increased. In the example shown in FIG. 2, the pulse applied condition is changed, that is, pulses up to 168 each having an amplitude of +27 V and a pulse width of 65 ns are applied. Under such condition, as can be seen from the characteristics shown in FIG. 2, the resistance value changes in a range as many as about five digits as the number of applied pulses is increased.

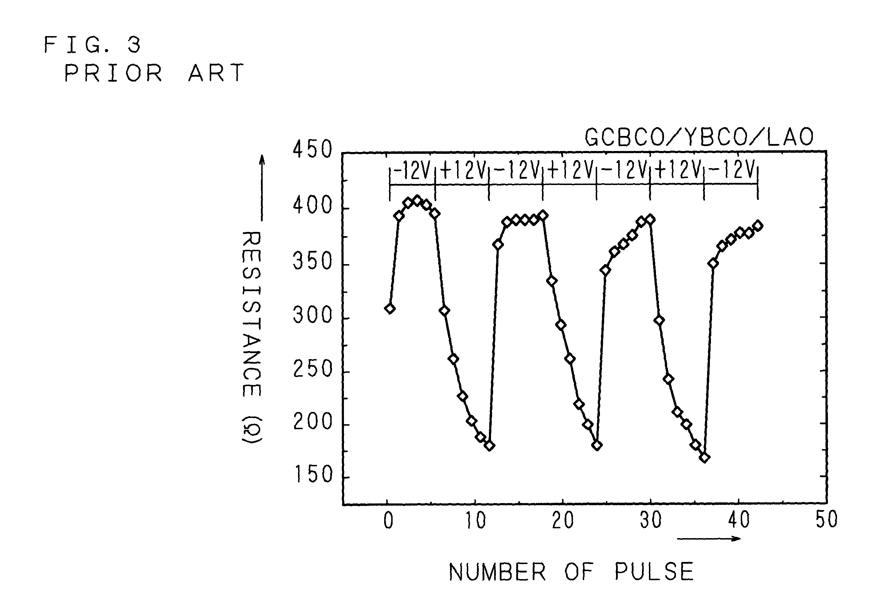

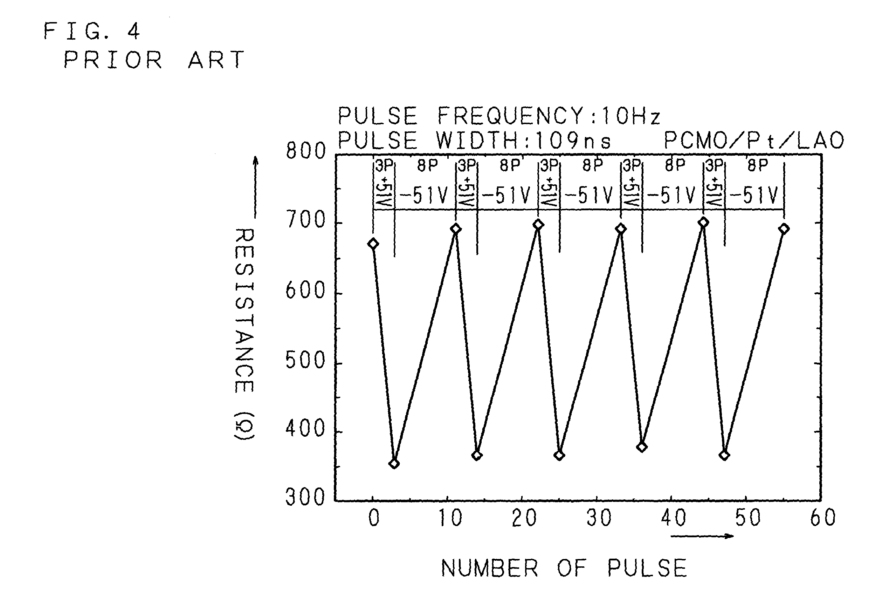

FIG. 3 and FIG. 4 are graphs schematically showing a relation between applied pulse polarity and a resistance value of the above variable resistive element. FIG. 3 shows a relation between the number of applied pulses and the resistance value when pulses of +12 V (positive polarity) and -12 V (negative polarity) are applied. In addition, FIG. 4 shows a relation between the number of applied pulses and the resistance value which is measured after pulses of +51 V (positive polarity) and -51 V (negative polarity) are continuously applied. As can be seen from FIG. 3 and FIG. 4, the resistance value can be increased (saturated state finally) by continuously applying the negative polarity pulses after it is reduced by applying positive polarity pulses several times. Thus, it can be understood that the element can be applied to a memory device by being set in a reset state when the positive polarity pulses are applied and in a writing state when the negative polarity pulses are applied thereto.

According to the conventional variable resistive element whose characteristics are shown in FIG. 1 through FIG. 4, the writing time is about several tens to 200 nanoseconds and an erasing operation can be performed by applying a voltage whose polarity is opposite to that in writing operation, for about several tens to 200 nanoseconds. In addition, when such variable resistive element (CMR material) is used, since it is not necessary to flow a large current to the metal wiring in writing operation, a tungsten wiring, polycrystalline silicon, a diffusion layer (an impurity region) of a silicon substrate or the like which is strong in the high-temperature heating process can be used as the lower wiring.

When the 1D1R type of memory cell is constituted by the variable resistive element formed of a variable resistive material such as CMR, and the diode formed by the PN junction, the sum of the forward threshold value of the diode and the voltage applied to the variable resistive element is applied to the memory cell at the time of reading operation. When the applied voltage is high at the time of reading operation, a reading disturbance in which the resistance value changes at the time of reading operation is generated and, then, the resistance value of the variable resistive element changes from a low resistance state to a high resistance state, so that it is necessary to reduce the reading voltage as much as possible. However, since the forward threshold value of the diode formed by the PN junction is relatively high (about 0.5 V), the reading disturbance is generated.

When the 1D1R type of memory cell constituted by the variable resistive element formed of the variable resistive material such as CMR material and the like and the diode formed by the PN junction is manufactured, a transistor (MOSFET) constituting a word line decoder and a bit line decoder for selecting the memory cell and a transistor constituting a peripheral circuit such as a read circuit are formed first, a diode constituted by PN junction of polycrystalline silicon is formed next and, then, the variable resistive element is formed. In this manufacturing method, it is necessary to separately perform a heating treatment for forming the diode by joining polycrystalline silicon comprising a p-type impurity and polycrystalline silicon comprising an n-type impurity, and a heating treatment for improving a crystalline property of the film of the variable resistive material deposited (formed) by a sputtering method or a CVD method. Therefore, since a diffusion layer of a source region and a drain region of the transistor (MOSFET) constituting the peripheral circuit of the memory device is enlarged and an effective gate length is shortened because the number of the heat treatments is increased, the characteristics of the transistor deteriorates because of a short-channel effect.

### BRIEF SUMMARY OF THE INVENTION

The present invention was made in view of the above problems and it is an object of the present invention to provide a memory cell constituted by a series circuit of a variable resistive element and a Schottky diode, thereby reducing a reading disturbance, and a memory device comprising such memory cells.

In addition, it is another object of the present invention to provide a manufacturing method of a memory cell in which an adverse affect on the characteristics of the transistor (MOSFET) constituting the peripheral circuit of the memory cell can be prevented by reducing the number of heat treatments when the memory cells are formed.

In a first aspect of the memory cell according to the present invention, the memory cell comprises a variable resistive element and a current control element controlling a current flowing in the variable resistive element, and is characterized in that the current control element is a Schottky diode.

In a second aspect of the memory cell according to the present invention, the memory cell in the first aspect is characterized in that the variable resistive element is formed of a resistive material having a perovskite-type crystalline structure.

In a third aspect of the memory cell according to the present invention, the memory cell in the first or second aspect is characterized in that a first electrode of the Schottky diode is a second conductive type impurity region formed on a first conductive type semiconductor substrate, and a second electrode of the same is metal film deposited on the impurity region.

In a fourth aspect of the memory cell according to the present invention, the memory cell in the third aspect is characterized in that the semiconductor substrate is a silicon substrate, and the Schottky diode has a Schottky barrier between the impurity region and a metal silicide film formed between the impurity region and the metal film.

In a fifth aspect of the memory cell according to the present invention, the memory cell in the third or fourth aspect is characterized in that the impurity region is selectively formed in an element isolation region formed in the semiconductor substrate.

In a sixth aspect of the memory cell according to the present invention, the memory cell in any one of the third to fifth aspects is characterized in that a variable resistive film constituting the variable resistive element is deposited on the second electrode of the Schottky diode by a self-aligning manner.

In a seventh aspect of the memory cell according to the present invention, the memory cell in the first or second aspect is characterized in that a first electrode of the Schottky diode is a polycrystalline silicon region selectively formed in the insulating film, and a second electrode of the sama is a metal film deposited on the polycrystalline silicon region.

In an eighth aspect of the memory cell according to the present invention, the memory cell in the seventh aspect is characterized in that the Schottky diode has a Schottky barrier between the polycrystalline silicon region and a metal silicide film formed between the polycrystalline silicon region and the metal film.

In a first aspect of the memory device according to the present invention, the memory device in which memory cells are located at positions where word lines and bit lines arranged in a matrix intersect with each other, and is characterized in that the memory cell is constituted by a series circuit including a variable resistive element and a Schottky diode controlling a current flowing in the variable resistive element, and one end of the series circuit is connected to the word line, and the other end of the same is connected to the bit line, respectively.

In a second aspect of the memory device according to the present invention, the memory device in the first aspect is characterized in that the variable resistive element is formed of a resistive material having a perovskite-type crystalline structure.

In a third aspect of the memory device according to the present invention, the memory device in the first or second aspect is characterized in that a first electrode of the Schottky diode is connected to the word line, a second electrode of the Schottky diode is connected to one end of the variable resistive element, and the other end of the variable resistive element is connected to the bit line.

In a fourth aspect of the memory device according to the present invention, the memory device in any one of the first to third aspects is characterized in that the word line is constituted by an impurity region selectively formed in an element isolation region formed in the semiconductor substrate.

In a fifth aspect of the memory device according to the present invention, the memory device in the fourth aspect is characterized in that the first electrode of the Schottky diode is the impurity region, and a second electrode o the same is a metal film deposited on the impurity region.

In a sixth aspect of the memory device according to the present invention, the memory device in the fifth aspect is characterized in that the semiconductor substrate is a silicon substrate, and the Schottky diode has a Schottky barrier between the impurity region and a metal silicide film formed between the impurity region and the metal film.

In a seventh aspect of the memory device according to the present invention, the memory device in the fifth or sixth aspect is characterized in that a variable resistive film constituting the variable resistive element is deposited on the second electrode of the Schottky diode by a self-aligning manner.

In an eighth aspect of the memory device according to the present invention, the memory device in any one of the first to third aspects is characterized in that the word line is constituted by a polycrystalline silicon region selectively formed in an insulating film.

In a ninth aspect of the memory device according to the present invention, the memory device in the eighth aspect is characterized in that the first electrode of the Schottky diode is the polycrystalline silicon region, and the second electrode of the same is a metal film deposited on the polycrystalline silicon region.

In a tenth aspect of the memory device according to the present invention, the memory device in the ninth aspect is characterized in that the Schottky diode has a Schottky barrier between the polycrystalline silicon region and a metal silicide film formed between the polycrystalline silicon region and the metal film.

In a first aspect of the manufacturing method of the memory cell according to the present invention, the manufacturing method of forming a memory cell constituted by a series circuit of a variable resistive element and a Schottky diode, on a semiconductor substrate, is characterized by comprising steps of forming an insulating film having openings on which impurity regions formed on one surface of the semiconductor substrate are exposed; depositing a metal film constituting an electrode of the variable resistive element in the openings of the insulating film; depositing a variable resistive film constituting a resistor of the variable resistive element on the metal film; and forming a Schottky diode by forming a metal silicide film between the impurity region and the metal film by a heat treatment.

In a second aspect of the manufacturing method according to the present invention, the manufacturing method in the first aspect is characterized in that the variable resistive film is deposited on the metal film in the opening by a self-aligning manner.

In a third aspect of the manufacturing method according to the present invention, the manufacturing method in the first or second aspect is characterized in that a temperature of the heat treatment is a temperature capable of improving a crystalline property of the variable resistive film.

In a fourth aspect of the manufacturing method according to the present invention, the manufacturing method in any one of the first to third aspects is characterized in that the semiconductor substrate is a silicon substrate, and the Schottky diode has a Schottky barrier between the metal silicide film and the impurity region.

In a fifth aspect of the manufacturing method according to the present invention, the manufacturing method of forming a memory cell constituted by a series circuit of a variable resistive element and a Schottky diode, on a semiconductor substrate, is characterized by comprising steps of forming an insulating film having openings on which impurity regions formed on one surface of the semiconductor substrate are exposed; depositing a metal film constituting an electrode of the variable resistive element in the opening of the insulating film; depositing a variable resistive film having a first film thickness and constituting a resistor of the variable resistive element on the metal film; forming a Schottky diode by forming a metal silicide film between the impurity region and the metal film by a heat treatment, and depositing a variable resistive film having a second film thickness and constituting the resistor on the variable resistive film having the first film thickness.

In a sixth aspect of the manufacturing method according to the present invention, the manufacturing method in the fifth aspect is characterized in that a temperature of the heat treatment is a temperature capable of improving a crystalline property of the variable resistive film having the first film thickness.

In a seventh aspect of the manufacturing method according to the present invention, the manufacturing method in the fifth or sixth aspect is characterized in that the semiconductor substrate is a silicon substrate, and the Schottky diode has a Schottky barrier between the metal silicide film and the impurity region.

In an eighth aspect of the manufacturing method according to the present invention, the manufacturing method in any of the fifth to seventh aspects is characterized by further comprising a step of further performing a heat treatment after deposition of the variable resistive film having the second film thickness, wherein a temperature of the heat treatment is a temperature capable of improving a crystalline property of the variable resistive film having the second film thickness and capable of reducing a resistance value of the metal silicide film.

In a ninth aspect of the manufacturing method according to the present invention, the manufacturing method of forming a memory cell constituted by a series circuit of a variable resistive element and a Schottky diode, on a semiconductor substrate, is characterized by comprising steps of: selectively forming a polycrystalline silicon region in an insulating film formed on one surface of the semiconductor substrate; depositing a metal film constituting an electrode of the variable resistive element on the polycrystalline silicon region; depositing a variable resistive film constituting a resistor of the variable resistive element on the metal film; and forming a Schottky diode by forming a metal silicide film between the polycrystalline silicon region and the metal film by a heat treatment.

In a tenth aspect of the manufacturing method according to the present invention, the manufacturing method in the ninth aspect is characterized in that a temperature of the heat treatment is a temperature capable of improving a crystalline property of the variable resistive film.

In an eleventh aspect of the manufacturing method according to the present invention, the manufacturing method in the ninth or tenth aspect is characterized in that the Schottky diode has a Schottky barrier between the metal silicide film and the polycrystalline silicon region.

In a twelfth aspect of the manufacturing method according to the present invention, the manufacturing method of forming a memory cell constituted by a series circuit of a variable resistive element and a Schottky diode, on a semiconductor substrate, is characterized by comprising steps of selectively forming a polycrystalline silicon region in an insulating film formed on one surface of the semiconductor substrate; depositing a metal film constituting an electrode of the variable resistive element on the polycrystalline silicon region; depositing a variable resistive film having a first film thickness and constituting a resistor of the variable resistive element on the metal film; forming a Schottky diode by forming a metal silicide film between the polycrystalline silicon region and the metal film by a heat treatment; and depositing a variable resistive film having a second film thickness and constituting the resistor on the variable resistive film having the first film thickness.

In a thirteenth aspect of the manufacturing method according to the present invention, the manufacturing method in the twelfth aspect is characterized in that a temperature of the heat treatment is a temperature capable of improving a crystalline property of the variable resistive film having the first film thickness.

In a fourteenth aspect of the manufacturing method according to the present invention, the manufacturing method in the twelfth or thirteenth aspect is characterized in that the Schottky diode has a Schottky barrier between the metal silicide film and the polycrystalline silicon region.

In a fifteenth aspect of the manufacturing method according to the present invention, the manufacturing method in any one of twelfth to fourteenth aspects is characterized by further comprising a step of further performing a heat treatment after deposition of the variable resistive film having the second film thickness, wherein a temperature of the heat treatment is a temperature capable of improving a crystalline property of the variable resistive film having the second film thickness and capable of reducing a resistance value of the metal silicide film.

In a sixteenth aspect of the manufacturing method according to the present invention, the manufacturing method in any one of the first to fourteenth aspects is characterized in that the metal film is formed of a refractory metal material.

In a seventeenth aspect of the manufacturing method according to the present invention, the manufacturing method in the sixteenth aspect is characterized in that the refractory metal material is selected from at least one of Pt, Ti, Co and Ni.

According to the present invention, since the memory cell is constituted by the series circuit of the variable resistive element and the Schottky diode, the threshold voltage of the diode in the forward direction can be lowered. Therefore, the nonvolatile memory cell in which the reading disturbance is not likely to be generated, and the memory device comprising such memory cells can be realized.

In addition, according to the present invention, since the resistive material having perovskite-type crystal structure is used in the variable resistive element, the resistance variation rate of the variable resistive element can be increased. Therefore, the memory cell and the memory device in which capacity can be highly increased and electrical control is easy can be realized.

Further, according to the present invention, since the first electrode of the Schottky diode is constituted by the impurity region of the semiconductor substrate, the semiconductor integrated circuit can be easily realized. In addition, since the second electrode is deposited to be formed in the vertical direction, the highly integrated memory cell can be realized. Still further, since the first electrode of the Schottky diode can serve as the word line also, the highly integrated memory device can be realized.

Yet further, according to the present invention, since the metal silicide film is formed between the impurity region of the silicon substrate, becoming the first electrode of the Schottky diode and the metal film becoming the second electrode thereof, and the Schottky barrier is formed between the metal silicide film and the silicon substrate (impurity region), the threshold voltage of the diode in the forward direction can be largely reduced as compared with the threshold voltage of the PN-junction diode in the forward direction. In addition, since the Schottky barrier is formed between the metal silicide film and the silicon substrate (impurity region), the stable diode characteristics can be obtained.

Yet further, according to the present invention, since the impurity region is formed in the element isolation region, the impurity region becoming the word line and the first electrode of the Schottky diode can be formed with high precision and high integration. Therefore, the integration degree of the memory cell and the memory device can be improved.

Yet further, according to the present invention, since the variable resistive film is formed on the second electrode of the Schottky diode by the self-aligning manner, the Schottky diode is precisely aligned to the variable resistive element in the vertical direction. Therefore, the resistance value of the variable resistive element can be accurately controlled and the integration degree of the memory cell and the memory device can be improved.

Yet further, according to the present invention, since the first electrode of the Schottky diode is constituted by the polycrystalline silicon region selectively formed on the insulating film, the structure in which the memory cell is stacked on the element other than the memory cell can be implemented. Therefore, the integration degree of the memory cell and the memory device can be improved.

Yet further, according to the present invention, since the metal silicide film is formed between the polycrystalline silicon region becoming the first electrode of the Schottky diode and the metal film becoming the second electrode thereof, and the Schottky barrier is formed between the metal silicide film and the polycrystalline silicon region, the threshold voltage of the diode in the forward direction can be largely reduced as compared with the threshold voltage of the PN-junction diode in the forward direction. In addition, since the Schottky barrier is formed between the metal silicide film and the silicon substrate (impurity region), the stable diode characteristics can be obtained.

Yet further, according to the present invention, the heat treatment of the metal film deposited to form the Schottky diode and the heat treatment for improving the crystalline property of the variable resistive film deposited to form the resistor of the variable resistive element are performed at the same time. Therefore, since the number of heat treatments can be reduced, the manufacturing method of the memory cell in which the adverse affect on the peripheral circuit is not generated can be realized.

Yet further, according to the present invention, the variable resistive film is deposited two times and the formation of the Schottky diode and the improvement of the crystalline property of the variable resistive film having the first film thickness can be performed at the same time by the heat treatment after deposition of the variable resistive film having the first film thickness. Therefore, since the number of heating treatments can be reduced, the manufacturing method of the memory cell in which the adverse affect on the peripheral circuit is not generated can be realized. In addition, since the variable resistive film having the second film thickness is deposited after improvement of the crystalline property of the variable resistive film having the first film thickness, the variable resistive film having the second film thickness can be deposited according to the crystalline property of the variable resistive film having the first thickness, whereby the manufacturing method of the memory cell in which the crystalline property is further improved as a whole of the variable resistive film can be realized.

Yet further, according to the present invention, the resistance value of the Schottky diode (especially the metal silicide film) can be further reduced by further performing the heating treatment after forming the variable resistive film having the second film thickness. In addition, since the crystalline property of the variable resistive film having the second thickness can be further improved according to the variable resistive film having the first film thickness, the crystalline property is largely improved as a whole of the variable resistive film.

The above and further objects and features of the invention will more fully be apparent from the following detailed description with accompanying drawings.

### BRIEF DESCRIPTION OF THE SEVERAL VIEWS OF THE DRAWINGS

FIG. 1 is a graph schematically showing a relation between the number of applied pulses and resistance value of a conventional variable resistive element;
FIG. 2 is a graph schematically showing a relation between the number of applied pulses and resistance value of the conventional variable resistive element;
FIG. 3 is a graph schematically showing a relation between the applied pulse polarity and resistance value of the conventional variable resistive element;
FIG. 4 is a graph schematically showing a relation between the applied pulse polarity and resistance value of the conventional variable resistive element;
FIG. 5A is a bock diagram showing a schematic constitution of a memory device according to the present invention;
FIG. 5B is a view showing conditions of voltages applied to the memory device according to the present invention at the time of reading;
FIG. 6 is a schematic diagram for explaining manufacturing steps in Embodiment 1 of a manufacturing method of a memory cell according to the present invention;
FIG. 7 is a schematic diagram for explaining manufacturing steps in Embodiment 1 of the manufacturing method of the memory cell according to the present invention;
FIG. 8 is a schematic diagram for explaining manufacturing steps in Embodiment 1 of the manufacturing method of the memory cell according to the present invention;
FIG. 9 is a schematic diagram for explaining manufacturing steps in Embodiment 1 of the manufacturing method of the memory cell according to the present invention;
FIG. 10 is a schematic diagram for explaining manufacturing steps in Embodiment 1 of the manufacturing method of the memory cell according to the present invention;
FIG. 11 is a schematic diagram for explaining manufacturing steps in Embodiment 1 of the manufacturing method of the memory cell according to the present invention;
FIG. 12 is a schematic diagram for explaining manufacturing steps in Embodiment 1 of the manufacturing method of the memory cell according to the present invention;
FIG. 13 is a schematic diagram for explaining manufacturing steps in Embodiment 2 of the manufacturing method of the memory cell according to the present invention;
FIG. 14 is a schematic diagram for explaining manufacturing steps in Embodiment 2 of the manufacturing method of the memory cell according to the present invention;
FIG. 15 is a schematic diagram for explaining manufacturing steps in Embodiment 2 of the manufacturing method of the memory cell according to the present invention;
FIG. 16 is a schematic diagram for explaining manufacturing steps in Embodiment 2 of the manufacturing method of the memory cell according to the present invention;
FIG. 17 is a schematic diagram for explaining manufacturing steps in Embodiment 2 of the manufacturing method of the memory cell according to the present invention;
FIG. 18 is a schematic diagram for explaining manufacturing steps in Embodiment 2 of the manufacturing method of the memory cell according to the present invention;
FIG. 19 is a schematic diagram for explaining manufacturing steps in Embodiment 2 of the manufacturing method of the memory cell according to the present invention; and
FIG. 20 is a schematic diagram for explaining manufacturing steps in Embodiment 2 of the manufacturing method of the memory cell according to the present invention.

### DETAILED DESCRIPTION OF THE PREFERRED EMBODIMENTS

Hereinafter, the present invention will be described with reference to the drawings showing its preferred embodiments.

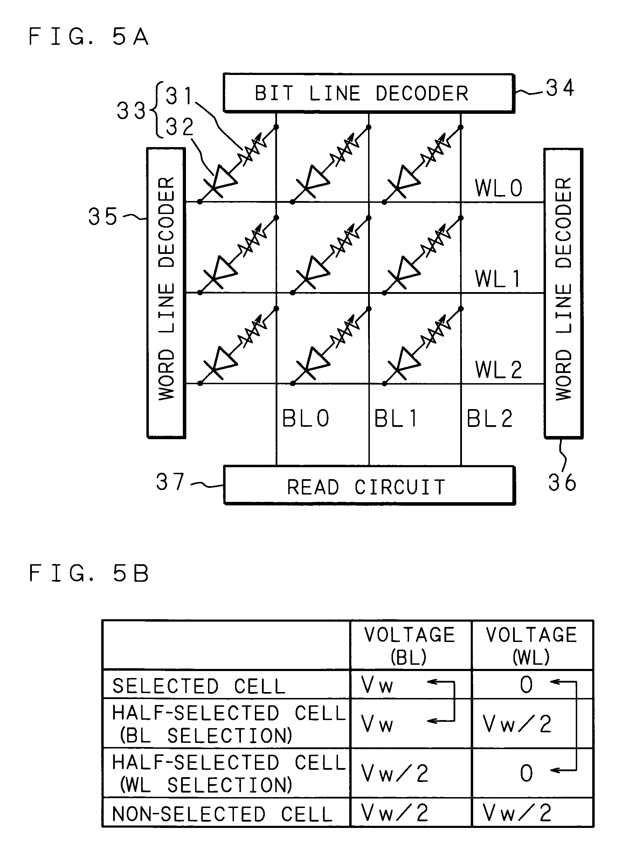

FIG. 5A and FIG. 5B are views for explaining a schematic constitution of a memory device according to the present invention. FIG. 5A is a circuit diagram showing a memory cell array in which memory cells are arranged in a matrix, bit lines and word lines connected to the memory cells, and peripheral circuits connected to the bit lines and the word lines. FIG. 5B is a table showing conditions of applied voltages when the circuit shown in FIG. 5A is read.

Referring to FIG. 5A, reference numeral 31 designates a variable resistive element whose resistance value varies depending on application of voltage and reference numeral 32 designates a Schottky diode which controls a current flowing in the variable resistive element 31. One variable resistive element 31 and one Schottky diode 32 are connected in series to each other and this series circuit constitutes each memory cell 33 according to the present invention. Here, in order to simplify the description, the memory cell array by 3 x 3 is illustrated. Since a resistance value of the variable resistive element 31 does not vary, that is, its resistance value is maintained while a voltage is not applied, the variable resistive element 31 can constitute a nonvolatile memory cell. This means that the memory device comprising a plurality of such memory cells according to the present invention is also a nonvolatile memory device.

In the memory device, the bit lines BL0, BL1 and BL2 (which will be simply referred to as the bit line BL when a distinction between them is not necessary hereinafter) are arranged in a column direction. One end of the bit line BL is connected to a bit line decoder 34, and the other end of the same is connected to a read circuit 37. The word lines WL0, WL1 and WL2 (which will be simply referred to as the word line WL when a distinction between them is not necessary hereinafter) are arranged in a row direction which intersect with the bit lines BL. Both ends of the word lines WL are connected to word line decoders 35 and 36, respectively. More specifically, the bit lines BL and word lines WL are arranged in a matrix, memory cells are located at positions where the bit lines BL and the word lines WL intersect with each other, which constitute the memory cell array (memory device) as a whole.

In addition, since the word line decoders 35 and 36 are arranged at both ends of the word lines WL, for example, the even-numbered word line WL and the odd-numbered word line WL can be connected to the word line decoders 35 and 36 alternately. Thus, a pitch of the word lines WL can be decreased and also a margin of a circuit arrangement (circuit size) of the word line decoders 35 and 36 can be increased. One end of the series circuit (that is, the memory cell 33 according to the present invention) constituted by the variable resistive element 31 and the Schottky diode 32 is connected to the word line WL and the other end of the same is connected to the bit line BL, respectively. The bit line decoder 34, and word line decoders 35 and 36 and the read circuit 37 constitute the peripheral circuits. In the peripheral circuit, a MOSFET (CMOSFET) is used, for example.

As a resistor, the variable resistive element 31 comprises a resistive material having a perovskite-type crystalline structure, a double aligned perovskite-type crystalline structure or the like which shows colossal magneto resistance or high temperature super conductivity. As a specific resistive material, Pr₍₁₋ₓ₎CaₓMnO₃ (0 < x < 1), La₍₁₋ₓ₎CaₓMnO₃ (0 < x < 1), Nd₍₁₋ₓ₎SrₓMnO₃ (0 < x < 1), Sr₂FeMoO₆, Sr₂FeWO₆ or the like is used. According to the resistance constituted by the above resistive material, since the resistance value varies when a voltage is applied, it can be used as memory means by replacing the resistance values before and after it varies with a signal. The Schottky diode 32 is constituted by forming a Schottky barrier by joining a semiconductor and metal. When metal silicide (refractory metal silicide) is formed by performing a heat treatment for silicon as a semiconductor and refractory metal as metal, respectively, Schottky barrier can be formed between the refractory metal silicide and silicon (at an interface). For example, in the Schottky diode having an interface between titanium silicide and n-type silicon, 0.2 V can be obtained as a forward threshold voltage. Since this value is a half or less as compared with a forward threshold voltage 0.5 V in a PN-junction diode, an influence of reading disturbance in the memory device, for example, can be largely reduced.

A first electrode (e.g., cathode/negative electrode) of the Schottky diode 32 is connected to the word line WL, a second electrode (e.g., anode/positive electrode) of the Schottky diode 32 is connected to one end of the variable resistive element 31 and the other end of the variable resistive element 31 is connected to the bit line BL.

Basic operations of the memory device such as writing, erasing and reading operations will be described. First, description will be made of a writing method in a case where the memory cell 33 at the position where the bit line BL0 and the word line WL0 intersect with each other is selected as a selected cell and data is written in this selected cell. A writing voltage Vw (V) (hereinafter, the unit (V) of voltage is omitted) is applied to the bit line BL0 of the selected cell and a voltage 0 is applied to the word line WL0 of the same, respectively. Thus, since the Schottky diode 32 of the memory cell 33 as the selected cell is forward biased, the writing voltage Vw is applied to the variable resistive element 31 and accordingly the resistance value of the variable resistive element 31 varies.

Since in other memory cells in the column direction which share the bit line BL0 but do not share the word line WL0 (memory cells located at and connected to the position where the bit line BL0 intersects with the word lines WL1 and WL2), the bit line BL is only selected among the bit lines BL and word lines WL, such cell is called a half-selected cell (BL selection). Although the writing voltage Vw is applied to the bit line BL0 of the half-selected cell (BL selection) similar to the selected cell, a voltage Vw/2 is applied to the word lines WL (word lines WL1 and WL2) so that a potential difference between both ends of the half-selected cell (BL selection) may become Vw/2. In addition, since in other memory cells in the row direction which share the word line WL0 but do not share the bit line BL0 (memory cells located at and connected to the position where the word line WL0 intersects with the bit lines BL1 and BL2), the word line WL is only selected among the bit lines BL and word lines WL, such cell is called a half-selected cell (WL selection). Although a voltage 0 is applied to the word line WL0 of the half-selected cell (WL selection) similar to the selected cell, a voltage Vw/2 is applied to the bit lines BL (bit line BL1 and BL2) so that a potential difference between both ends of the half-selected cell (WL selection) may become Vw/2. In other words, by setting the writing voltage Vw such that writing into the variable resistive element 31 may not be performed when the potential difference between both ends of the half-selected cell is Vw/2, writing into the half-selected cell is prevented.

Furthermore, since the same voltage Vw/2 is applied to both ends of non-selected cells (memory cells located at and connected to the position where the bit lines BL1 and BL2 intersect with the word lines WL1 and WL2), potential difference does not occur between both ends of the memory cell and the writing into the variable resistive element 31 is not performed. Therefore, writing is performed for the selected cell only, while writing into the half-selected cell and into the non-selected cell is not performed. The above relationship is summarized in the table in FIG. 5B. The voltage (BL) which is applied to the bit line BL and the voltage (WL) which is applied to the word line WL are shown in the vertical sections and the kinds of memory cells classified by a selected state are shown in the lateral sections in the table. In addition, the selected states of the memory cells are classified into four kinds of the selected cell, the half-selected cell (BL selection), the half-selected cell (WL selection) and the non-selected cell. Although the half-selected cell is distinguished from the non-selected cell as a matter of conveyance of the description, the half-selected cell can be contained in the non-selected cell. In addition, the connection direction (rectification direction) of the Schottky diode 32 can be appropriately reversed and in this case, by appropriately changing the direction (polarity) of the applied voltage, the same operation as in the case the connection direction (rectification direction) of the Schottky diode 32 is not reversed can be performed.

The erasing operation can be performed by elongating a time for applying the writing voltage. In addition, the reading operation can be performed by applying the reading voltage Vr to the bit line BL of the selected cell and a voltage 0 to the word line WL of the same, respectively. Furthermore, similar to the case of the writing operation, a potential difference applied to both ends of the non-selected cell is set so as to be Vr/2. That is, the writing voltage Vw in FIG. 5B may be replaced with the reading voltage Vr.

### (Embodiment 1)

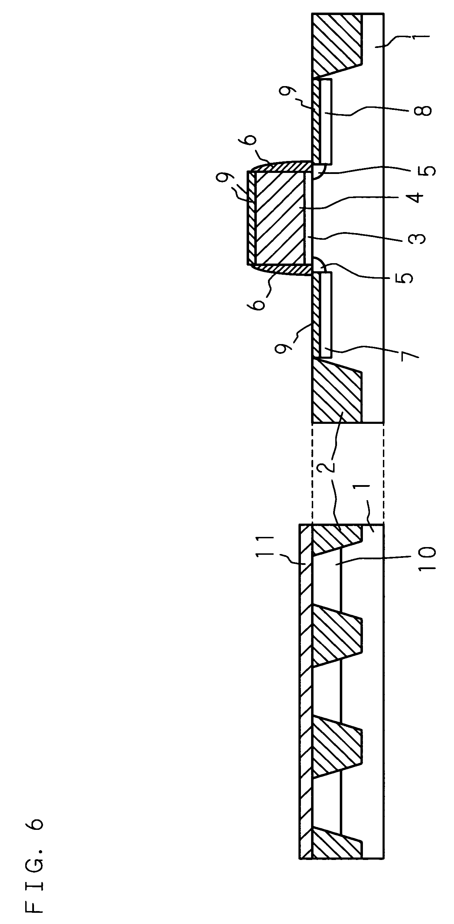

FIG. 6 through FIG. 12 are schematic diagrams for explaining manufacturing steps in Embodiment 1 of a manufacturing method of a memory cell according to the present invention. In each figure, a memory cell region (hereinafter, referred to as the memory region) in which the memory cell is formed and a peripheral circuit region (hereinafter, referred to as the peripheral region) in which a peripheral circuit is formed are shown in the left and right sides, respectively. Each figure shows a sectional structure of the memory cell (the series circuit of the Schottky diode and the variable resistive element) and the peripheral circuit (an N-channel MOSFET used in the peripheral circuit is shown as a representative example) in the manufacturing steps. In addition, in each figure, oblique lines for showing the section are appropriately omitted. Although the MOSFET is constituted by combining a P-channel MOSFET and the N-channel MOSFET in general, the N-channel MOSFET is only shown here for simplification.

FIG. 6 is a schematic diagram showing a state where an element isolation region, the first electrode of the Schottky diode and the N-channel MOSFET are formed on a semiconductor substrate. An element isolation region 2 is formed to be appropriately patterned on a semiconductor substrate (referred to as the substrate hereinafter) 1. The substrate 1 is a first conductive type (p-type) silicon single crystal, for example. In addition, the substrate 1 may be a semiconductor film and the like formed on an insulating substrate. The element isolation region 2 is formed of a silicon oxide film (SiO₂), for example. An impurity region 10 can be formed in the memory region by a self-aligning manner by ion implantation using a second conductive type (n-type) ion species, which is different from that of the substrate 1, on the element isolation region 2. The impurity region 10 becomes the first electrode of the Schottky diode and word lines WL formed in the later step. Since the impurity region 10 can be formed in the self-aligning manner in element isolation regions 2, it can be formed in a high density and, as a result, a high-integrated memory cell can be formed. Here, three impurity regions 10 (corresponding to the three word lines WL) are illustrated. In addition, since the impurity region 10 is formed by the self-aligning manner in the element isolation regions 2, it can be formed by a precise pattern and as a result, characteristics of the Schottky diode can be surely unified. In the memory region, an insulating film 11 such as silicon oxide film, for example, is formed in addition to the impurity region 10. By forming the insulating film 11, since the element isolation region 2 and the impurity region 10 in the memory region can be coated, the memory region is not influenced by the processing for the peripheral region.

In the peripheral region, the N-channel MOSFET (referred to as the MOSFET hereinafter) is formed according to a normal CMOS processing step. By performing ion implantation using a second conductive type ion species, which is different from that of the substrate 1, into a channel portion of the MOSFET region surrounded by the element isolation region 2, the channel concentration is controlled. Then, a gate insulating film 3 is formed by thermal oxidation or the like and, then, polycrystalline silicon is deposited by an LP-CVD method and the like. Then, polycrystalline silicon is patterned by photolithography to form a gate electrode 4 formed of polycrystalline silicon. The integration degree can be improved by minimizing a dimension of the gate electrode 4 in the direction of the channel length in general. Then, the second conductive type ion species are implanted to a portion of the substrate 1 corresponding to the end portion of the gate electrode 4 in the channel-length direction to form a LDD (Lightly Doped Drain) region 5 having low concentration. Then, a silicon oxide film is deposited in the MOSFET region and a sidewall 6 is formed by etching back. Then, the second conductive type ion species are implanted in a high concentration to form a source region 7 and a drain region 8. In order to form a silicide in the source region 7 and the drain region 8 by the self-aligning manner (that is, to form a salicide : self-aligned silicide), a silicon surface of the gate electrode 4, the source region 7 and the drain region 8 is exposed and, then, a cobalt (Co) film, for example, is formed on a whole of the substrate 1 and heated by ramp annealing and the like. Cobalt reacts with silicon by this heating and a cobalt silicide film 9 is formed. In addition, since the cobalt deposited on the surface of the insulating film 11 does not react with the silicon oxide film by the heating, cobalt silicide is not formed in the memory region. After the heating, the non-reacted cobalt film is appropriately removed.

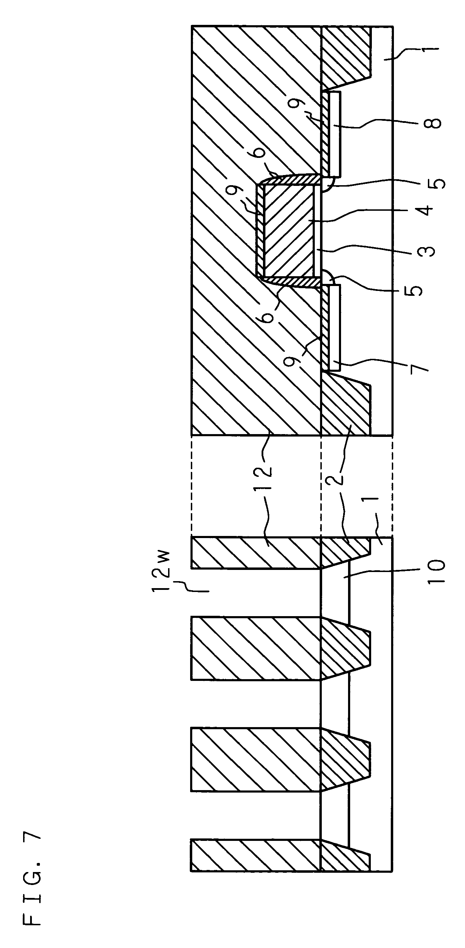

FIG. 7 is a schematic diagram showing a state where openings for the electrodes of the Schottky diode are formed in an interlayer insulating film in order to form the memory cells. For example, an insulating film 12 formed of a silicon oxide film is formed as the interlayer insulating film 12 and flattened by a CMP (Chemical Mechanical Polishing) method and the openings 12w are formed in the insulating film 12 in the memory region. In addition, the opening 12w is appropriately formed so as to be aligned to the impurity region 10.

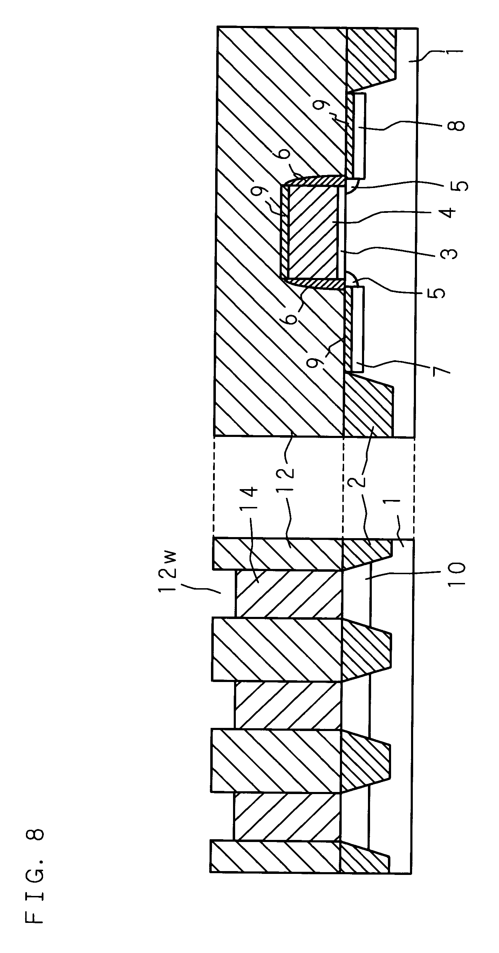

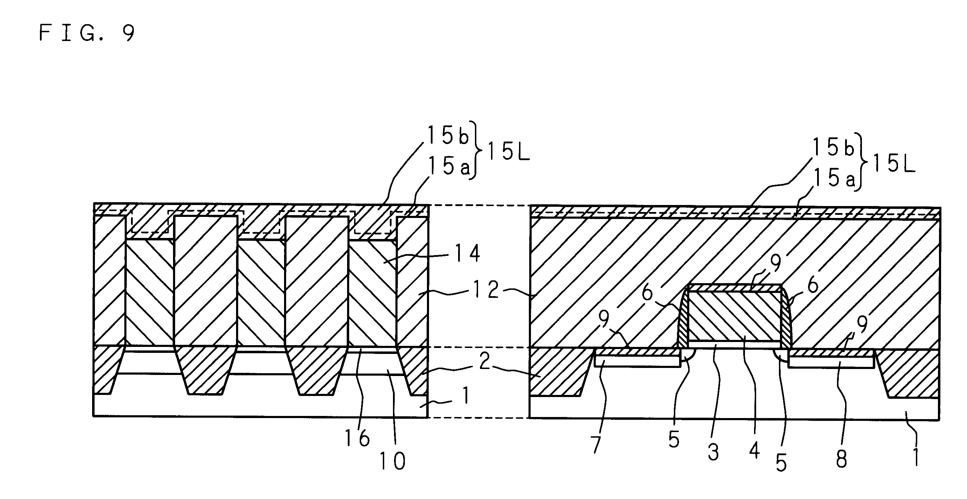

FIG. 8 is a schematic diagram showing a state where the second electrodes of the Schottky diode are formed. A metal film 14 serving as both second electrode of the Schottky diode and lower electrode of the variable resistive element is formed (deposited) by being buried in the opening 12w with the CMP method or the etching back method. At this time, burying depth is adjusted such that an upper end of the metal film 14 may be positioned on the side of the substrate 1 from the upper end of the opening 12w. In other words, the metal film 14 is formed so as to be lower than a height of the opening 12w so that an upper end of the opening 12w is exposed. As a result, since the upper end of the opening 12w is remained, a variable resistive film 15L (resistor 15) to be formed at the next step (see FIG. 9) can be formed in the opening 12w (metal film 14) by the self-aligning manner. A material of the metal film 14 is preferably a refractory metal material, for example, and especially, any one of Pt, Ti, Co and Ni or appropriate combination thereof, in view of adhesiveness with the material of the variable resistive film 15L to be formed later, safety and the like.

FIG. 9 is a schematic diagram showing a state where the variable resistive film is deposited. The variable resistive film 15L is deposited so as to fill the upper end portions of the openings 12w. A film thickness of the variable resistive film 15L is appropriately determined such that a resistance value of the resistor 15 to be described later may be a predetermined value. As the variable resistive film 15L, Pr₍₁₋ₓ₎CaₓMnO₃ (0 < x < 1) (hereinafter, refereed to as the PCMO) is used, for example. The variable resistive film 15L consists of a stacked structure of a first variable resistive film 15a and a second variable resistive film 15b. First, PCMO is deposited to have a first film thickness thinner than a film thickness of the variable resistive film 15L to form the first variable resistive film 15a and heating treatment is performed for the film at a first temperature. The heat treatment at the first temperature is performed rapidly for a short time using a RTA (Rapid Thermal Anneal) method in order to reduce an affect on the MOSFET, the impurity region 10 and the like. In addition, the first temperature has to satisfy a condition that the metal film 14 (the second electrode of the Schottky diode and the lower electrode of the variable resistive element) reacts with the impurity region 10 (silicon) and becomes metal silicide (refractory metal silicide) so that a metal silicide film 16 can be formed (about 800°C, in case of Pt), and crystalline property of the first variable resistive film 15a is improved (about 600°C, in case of PCMO).

That is, when the heat treatment is performed at the first temperature satisfying the above conditions, the metal silicide film 16 is formed and also the crystalline property of the first variable resistive film 15a can be improved. When the metal silicide film 16 is formed, as a result, a Schottky barrier is formed between the metal silicide film 16 and the impurity region 10. As a result, the Schottky diode whose first electrode is the impurity region 10 and whose second electrode is the metal film 14 (metal silicide film 16) is formed. In addition, since the first electrode of the impurity region 10 of the Schottky diode is n-type, it becomes a cathode and the metal film 14 as the second electrode of the Schottky diode becomes an anode.

After the heat treatment at the first temperature, PCMO is deposited to form the second variable resistive film 15b having a second film thickness so as to be equal to the film thickness of the variable resistive film 15L, together with the first film thickness of the first variable resistive film 15a, and heat treatment for it is performed at a second temperature. The metal silicide film 16 formed by the heat treatment at the first temperature is lowered its resistance by the heat treatment at the second temperature and a crystalline property of the second variable resistive film 15b deposited according to the crystalline property of the first variable resistive film 15a is further improved. In addition, the second temperature has to satisfy the condition that the resistance of the metal silicide film 16 is lowered and the crystalline property of the second variable resistive film 15b is improved. Note that, the second temperature may be the same as the first temperature or not more than the first temperature. In order to form the variable resistive film 15L having preferable crystalline property, the first film thickness of the first variable resistive film 15a is preferably thinner than the second film thickness of the second variable resistive film 15b. Here, the reason why the variable resistive film 15L is deposited (formed) by two separate operations is that since the second variable resistive film 15b is formed reflecting the crystalline property of the lower first variable resistive film 15a, the crystalline property of the second variable resistive film 15b is further improved as compared with a case where it is formed by one deposition process. In addition, although the variable resistive film 15L is formed by two separate deposition processes in the above, it may be formed by one deposition process. In that case, after the variable resistive film 15L is formed so as to have the predetermined film thickness by one deposition, the crystalline property of the variable resistive film 15L is improved and the metal silicide film 16 is formed by one heating treatment, whereby the Schottky diode is formed.

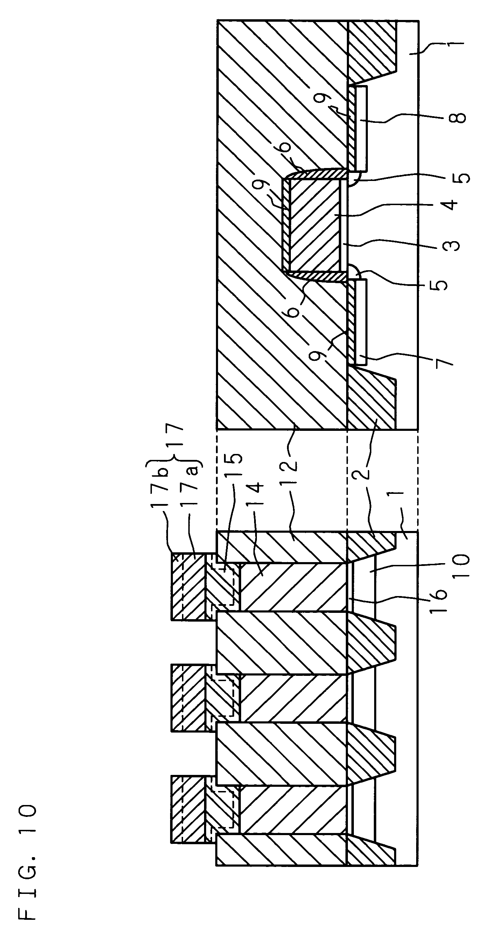

FIG. 10 is a schematic diagram showing a state where a variable resistive element is formed. After the heat treatment at the second temperature, a metal film 17 comprising a Pt film 17a and a TiN film 17b is formed on a whole surface of the variable resistive film 15L. Then, the TiN film 17b and the Pt film 17a are sequentially processed by photolithography and anisotropic etching and the variable resistive film 15L is etched using the processed Pt/TiN (the Pt film 17a and the TiN film 17b) as a mask to form the resistor 15. Since the variable resistive film 15L is processed using the processed Pt/TiN as a mask, the resistor 15 and the metal film 17 are formed by the self-aligning manner.

Then, a variable resistive element having the metal film 14 connected to one end of the resistor 15 as the lower electrode and the metal film 17 connected to the other end of the resistor 15 as the upper electrode is formed. Since the metal film 14 is also as the second electrode of the Schottky diode, the second electrode of the Schottky diode is in a state it is connected to one end of the variable resistive element by the self-aligning manner. Therefore, the Schottky diode and the variable resistive element can be surely aligned to each other to be formed and the integration degree can be further improved. Since the metal film 14 and the resistor 15 are aligned to each other by the self-aligning manner, an area of the lower electrode of the variable resistive element is accurately controlled and its resistance value is accurately controlled. Furthermore, since the metal film 17 and the resistor 15 are also aligned to each other by the self-aligning manner, the resistance value can be accurately controlled and also the integration degree is further improved.

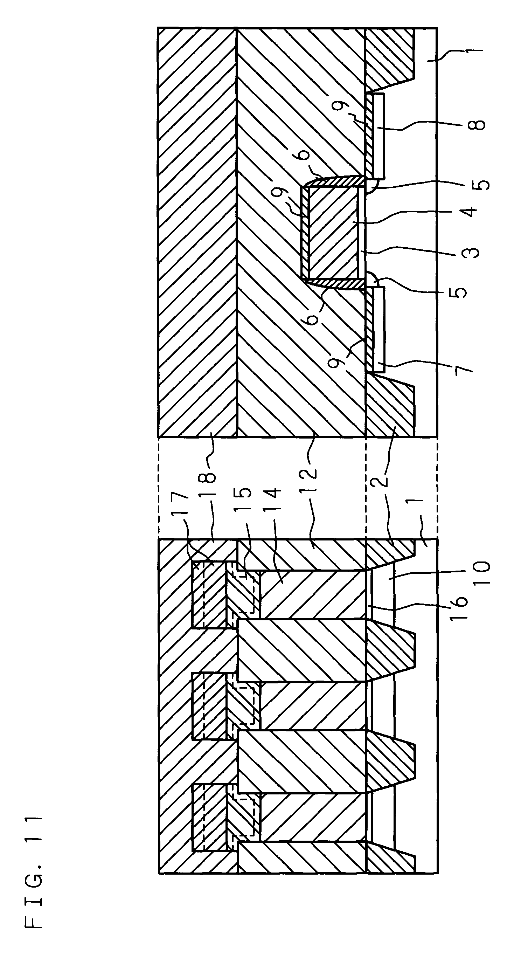

FIG. 11 is a schematic diagram showing a state where the surface is flattened before a wiring is formed. An insulating film 18 formed of a silicon oxide film, for example, is deposited on the insulating film 12 and the metal film 17 as an interlayer insulating film, and then flattened by the CMP method or the like.

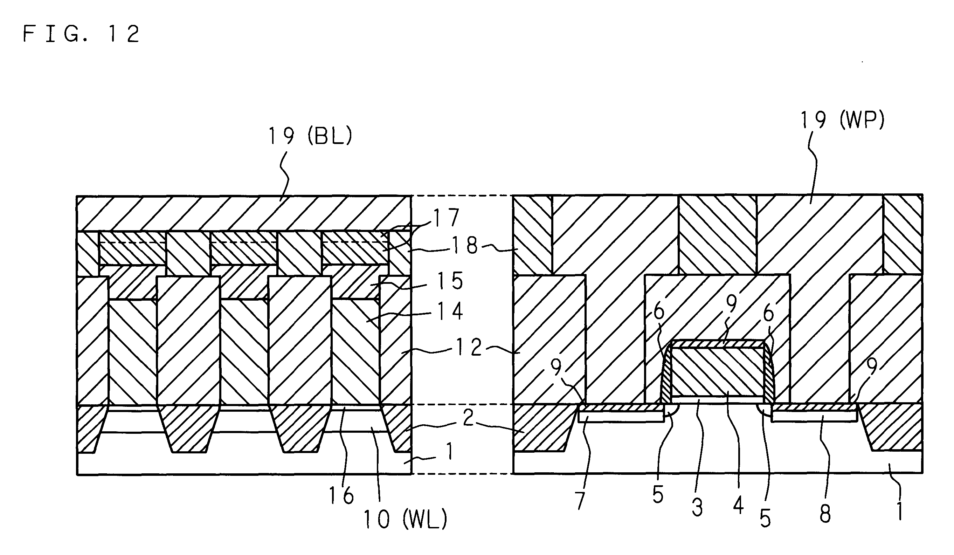

FIG. 12 is a schematic diagram showing a state where a wiring is formed. For example, it shows a state where a tungsten wiring 19 is formed by damascene technique using tungsten. As described above, the elements in the peripheral region and the elements in the memory region can be formed, respectively without affecting each other. The tungsten wiring 19 (BL) and the impurity region 10 (WL) are formed as the bit line BL and the word line WL in the memory region, respectively. Then, the memory cell at the position where the word line WL and the bit line BL intersect with each other is selected and the writing, erasing and reading operations can be performed for it. In addition, since the tungsten wiring 19 (WP) is formed in the peripheral region as the circuit wiring, the signal processing required for the memory device can be performed.

### (Embodiment 2)

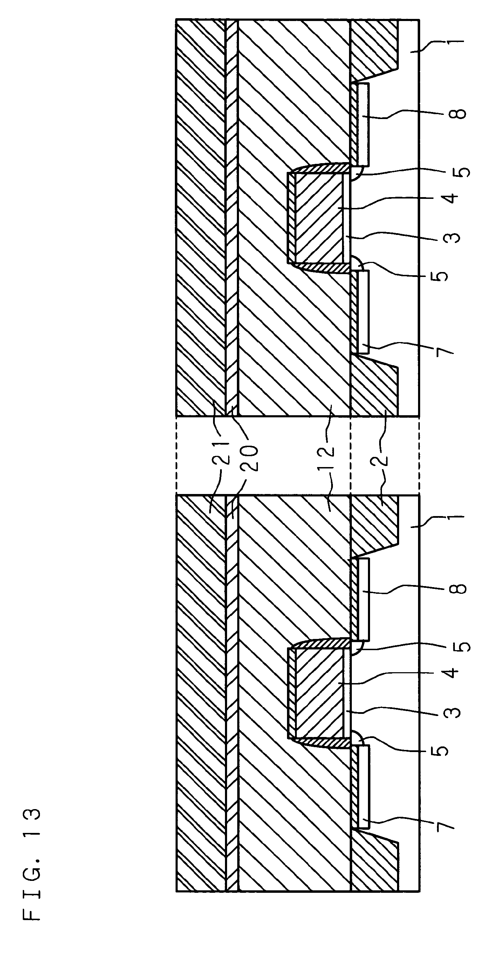

FIG. 13 through FIG. 20 are schematic diagrams for explaining manufacturing steps in Embodiment 2 of a manufacturing method of a memory cell according to the present invention. In each figure. a memory cell region (hereinafter, -referred to as the memory region) in which the memory cell is formed and a peripheral circuit region (hereinafter, referred to as the peripheral region) in which a peripheral circuit is formed are shown in the left and right sides. respectively. Each figure shows a sectional structure of the memory cell (the series circuit of the Schottky diode and the variable resistive element) and the peripheral circuit (an N-channel MOSFET used in the peripheral circuit is shown as a representative example) in the manufacturing steps. In the memory region, a peripheral circuit (a part of the peripheral circuit and the like) can be provided at a lower portion of the memory cell and as an example of the peripheral circuit, a case where the MOSFET is formed at the lower portion of the memory cell is shown. In addition, in each figure, oblique lines for showing the section are appropriately omitted. Although the CMOS is constituted by combining a P-channel MOSFET and the N-channel MOSFET in general, the N-channel MOSFET is only shown here for simplification. Furthermore, the same or corresponding parts as in Embodiment 1 are allotted to the same reference numerals (a part of them is omitted) and descriptions therefor will not be given. In addition, similar to the case in Embodiment 1, a substrate 1 may be a semiconductor film and the like formed on an insulating substrate.

FIG. 13 is a schematic diagram showing a state where the N-channel MOSFET is formed and then the surface is flattened. That is, the N-channel MOSFET (hereinafter, referred to as the MOSFET) is formed and, then, an insulating film 12, a stopper film 20 and an insulating film 21 are stacked. The insulating film 12 formed of a silicon oxide film, for example, is formed as an interlayer insulating film and flattened by a CMP (Chemical Mechanical Polishing) method and then a nitride film (SiN) is formed as the stopper film 20 serving as a stopper for etching. In addition, steps until the insulating film 12 is formed are the same as the forming steps of the peripheral region shown in FIG. 6 and FIG. 7 (Embodiment 1), in a memory region and a peripheral region. After the stopper film 20 was formed, the insulating film 21 formed of a silicon oxide film, for example, is formed as the interlayer insulating film.

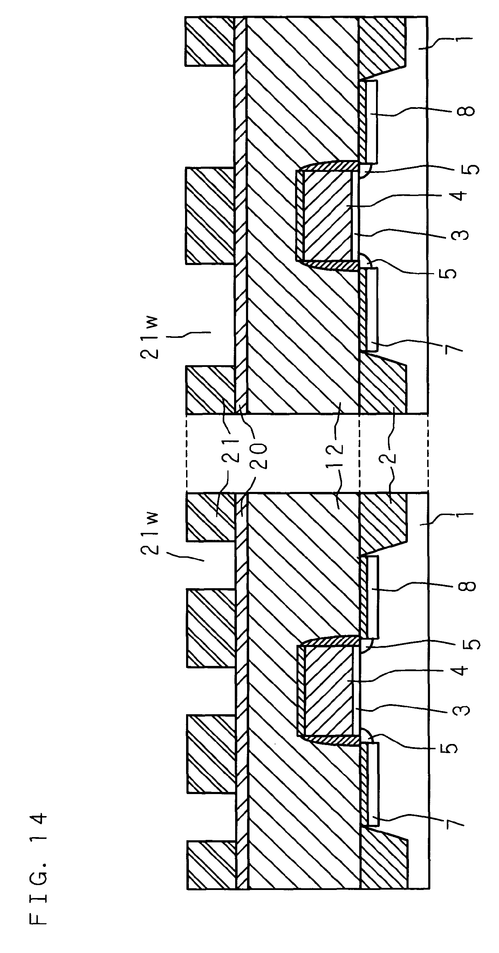

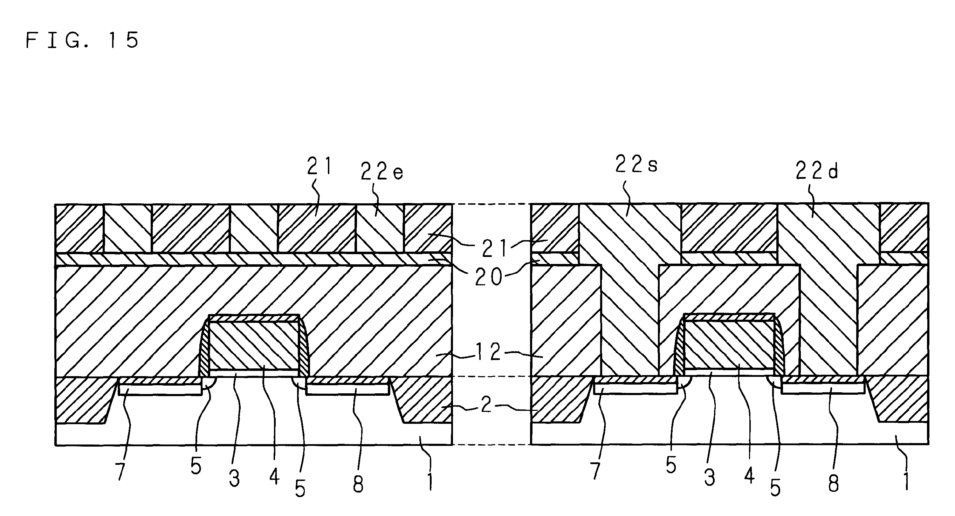

FIG. 14 is a schematic diagram showing a state where openings for forming the memory cell in the interlayer insulating film and openings for forming contacts with the MOSFET are formed. By using the stopper film 20 as a stopper, the insulating film 21 is etched away to have a predetermined pattern by photolithography and anisotropic etching. That is, in the memory region, openings 21w for forming polycrystalline silicon regions 22e (see FIG. 15) to be formed at a later step are formed, and in the peripheral region, openings 21w for forming a source electrode 22s and a drain electrode 22d (see FIG. 15) to be formed at a later step are formed. Then, in the peripheral region, in order to contact with a source region 7 and a drain region 8, openings (windows for contacts) to the source region 7 and the drain region 8 are further formed by partially removing the stopper films 20 exposed to the openings 21w.

FIG. 15 is a schematic diagram showing a state where polycrystalline silicon is deposited (filled) in the openings 12w. The polycrystalline silicon regions (22e, 22s and 22d) are formed (deposited) by being buried in the openings 21w having a predetermined pattern formed on the insulating film 21. Polycrystalline silicon containing phosphorus, for example, in a high concentration is deposited on the whole surface and flattened by the CMP method or the etching back method. Thus, the polycrystalline silicon region 22e in the memory region and the source electrode 22s and the drain electrode 22d formed of polycrystalline silicon in the peripheral region are selectively formed in the openings 21w. The reason why polycrystalline silicon containing phosphorus in a high concentration is used as the impurity is that since the polycrystalline silicon region 22e becomes a first electrode of the Schottky diode (and word line WL), it preferably has low resistance together with the source electrode 22s and the drain electrode 22d. Since the polycrystalline silicon region 22e contains phosphorus as the impurity, it becomes the n-type.

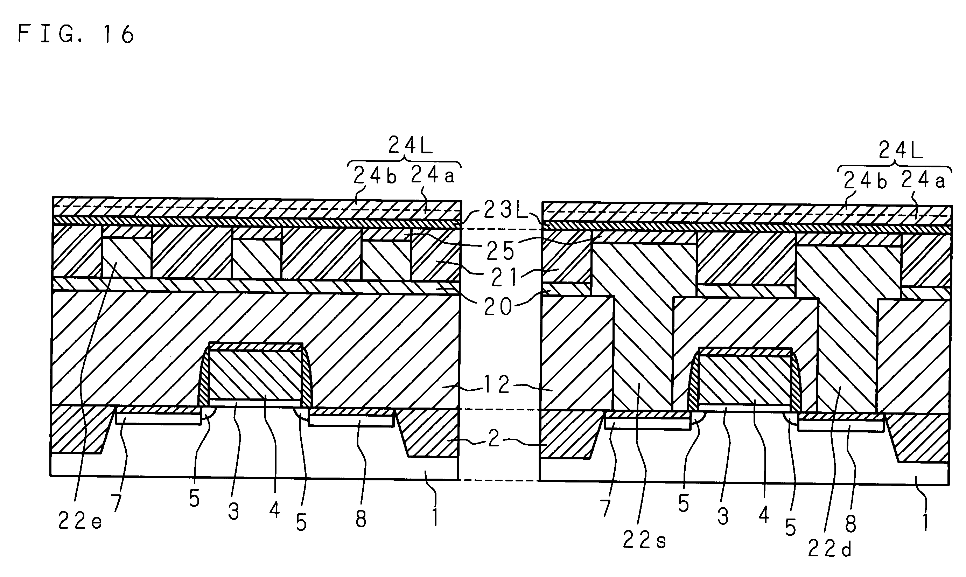

FIG. 16 is a schematic diagram showing a state where a variable resistive film is deposited. A metal film 23L serving as both second electrode of the Schottky diode and lower electrode of the variable resistive element is deposited on the flattened surface of the insulating film 21, the polycrystalline silicon region 22e, the source electrode 22s and the drain electrode 22d. In addition, since the metal film 23L is not necessary on the surface of the source electrode 22s and the drain electrode 22d in principle, it may not be deposited. A material of the metal film 23L is preferably a refractory metal material, for example, and especially, any one of Pt, Ti, Co and Ni or appropriate combination thereof, in view of adhesiveness with a material of a variable resistive film 24L (24a and 24b) to be formed later, safety and the like. In addition, similar to the case in Embodiment 1, a polycrystalline silicon film 22e and a metal film 23L are formed by being buried in the openings of the insulating film 21 and a variable resistive film 24L (24b on the side of the metal film 23L among 24a and 24b) may be further formed in the openings by the self-aligning manner.

The metal film 23L is formed and, then, the variable resistive film 24L is deposited. A film thickness of the variable resistive film 24L is appropriately determined such that a resistance value of a resistor 24 may become a predetermined value. As the variable resistive film 24L, Pr(₁₋ₓ)CaₓMnO₃ (0 < x < 1) (hereinafter, refereed to as the PCMO) is used, for example. The variable resistive film 24L is a stacked structure consisting of the first variable resistive film 24a and the second variable resistive film 24b. First, PCMO is deposited to have a first film thickness thinner than a film thickness of the variable resistive film 24L to form the first variable resistive film 24a and heating treatment is performed for the film at a first temperature. The heat treatment at the first temperature is performed rapidly for a short time using a RTA (Rapid Thermal Anneal) method and the like in order to reduce an affect on the MOSFET, the polycrystalline silicon region 22e and the like. In addition, similar to Embodiment 1, the first temperature has to satisfy a condition that the metal film 23L (the second electrode of the Schottky diode and the lower electrode of the variable resistive element) reacts with the polycrystalline silicon 22e to become metal silicide (refractory metal silicide) so that a metal silicide film 25 can be formed (about 800°C, in case of Pt), and a crystalline property of the first variable resistive film 24a is improved (about 600°C, in case of PCMO).

That is, when the heat treatment is performed at the first temperature satisfying the above condition, the metal silicide film 25 is formed and also the crystalline property of the first variable resistive film 24a can be improved. When the metal silicide film 25 is formed, as a result, a Schottky barrier is formed between the metal silicide film 25 and the polycrystalline silicon 22e. As a result, the Schottky diode whose first electrode is the polycrystalline silicon region 22e and whose second electrode is the metal film 23L (metal silicide film 25) is formed. In addition, since the polycrystalline silicon 22e as the first electrode of the Schottky diode is n-type, it becomes a cathode and the metal film 23L as the second electrode of the Schottky diode becomes an anode. Since the polycrystalline silicon region 22e and the metal silicide film 25 are formed so as to coincide with the openings by the self-aligning manner, they can be formed by a precise pattern and as a result, characteristics of the Schottky diode can be surely unified.

After the heat treatment at the first temperature, PCMO is deposited to form the second variable resistive film 24b having a second film thickness so as to be equal to the film thickness of the variable resistive film 24L, together with the first film thickness of the first variable resistive film 24a, and a heat treatment for it is performed at a second temperature. The metal silicide film 25 formed by the heat treatment at the first temperature is lowered its resistance by the heat treatment at the second temperature and a crystalline property of the second variable resistive film 24b deposited according to the crystalline property of the first variable resistive film 24a is further improved. In addition, the second temperature has to satisfy the condition that the resistance of the metal silicide film 25 is lowered and the crystalline property of the second variable resistive film 24b is improved. Note that, the second temperature may be the same as the first temperature or not more than the first temperature. In order to form the variable resistive film 24L having preferable crystalline property, the first film thickness of the first variable resistive film 24a is preferably thinner than the second film thickness of the second variable resistive film 24b. Here, the reason why the variable resistive film 24L is deposited by two separate deposition processes is that since the second variable resistive film 24b is formed reflecting the crystalline property of the lower first variable resistive film 24a, the crystalline property thereof is further improved as compared with a case where it is formed by one deposition process. In addition, although the variable resistive film 24L is formed by two separate deposition processes in the above, it may be formed by one deposition process. In that case, after the variable resistive film 24L is formed so as to have the predetermined film thickness by one deposition process, the crystalline property of the variable resistive film 24L is improved and the metal silicide film 25 is formed by one heating treatment, whereby the Schottky diode is formed.

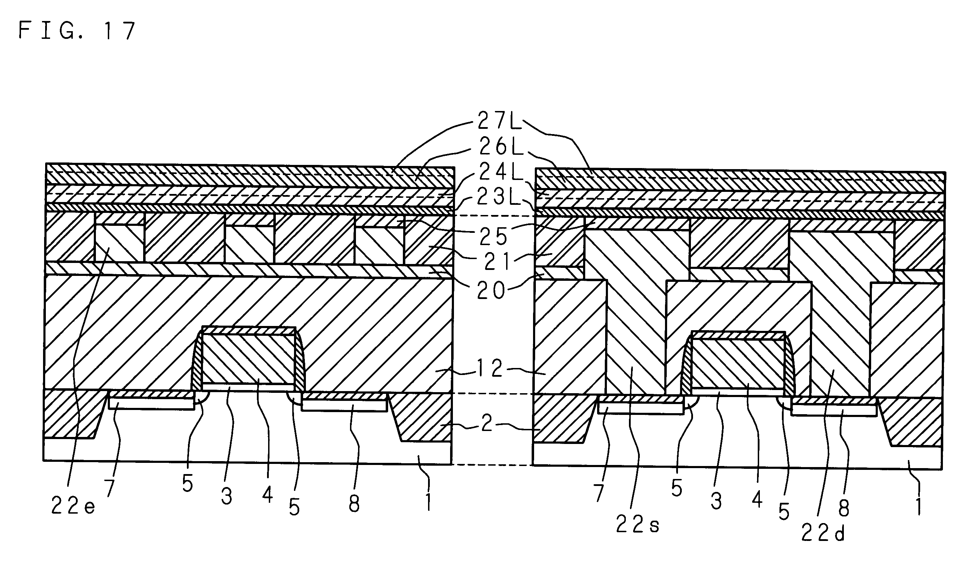

FIG. 17 is a schematic diagram showing a state where a metal film becoming the upper electrode of the variable resistive element is deposited. A metal film 26L serving as the upper electrode of the variable resistive element is deposited on the whole surface of the variable resistive film 24L. A material of the metal film 26L is preferably a refractory metal material, for example, and especially, any one of Pt, Ti, Co and Ni or appropriate combination thereof, in view of adhesiveness with the variable resistive film 24L, safety and the like. Here, as the metal film 26L, a Pt film was used. Then, a hard mask film 27L formed of a TiN film is deposited on the whole surface of the metal film 26L, as a mask for hard mask etching when the metal film 26L is etched away, and the metal film 26L and the hard mask film 27L are stacked to be formed.

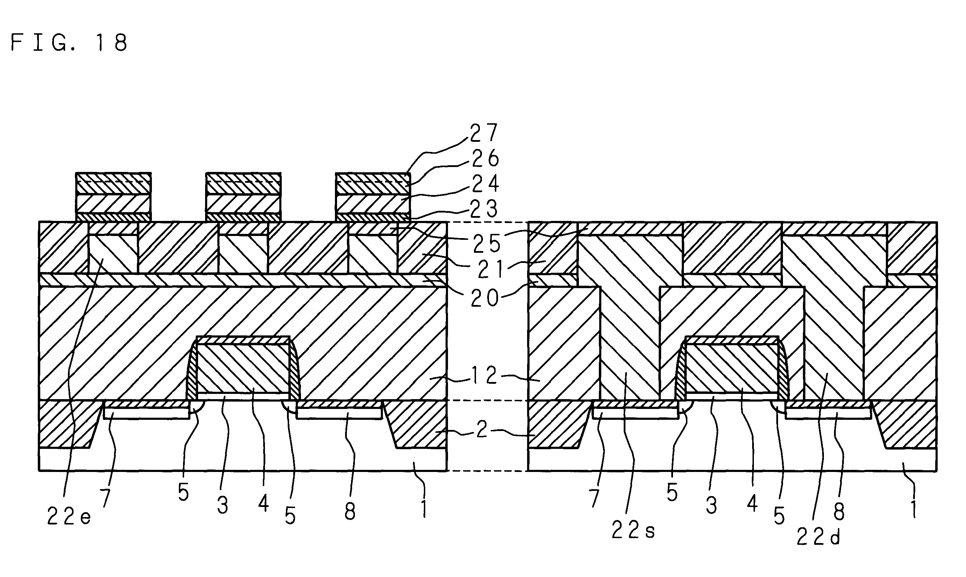

FIG. 18 is a schematic diagram showing a state where a variable resistive element is formed. After the step shown in FIG. 17, the hard mask film 27L is processed by photolithography and anisotropic etching and a hard mask 27 having a predetermined pattern (more specifically, a pattern of the upper electrode of the variable resistive element) is formed. Then, by etching away the metal film 26L, the variable resistive film 24L and the metal film 23L using the hard mask 27 as a mask, a metal film 26 (and the hard mask 27) as the upper electrode of the variable resistive element, the resistor 24 and a metal film 23 as the lower electrode of the variable resistive element are formed.

Since the metal film 23 is also as the second electrode of the Schottky diode, the second electrode of the Schottky diode is in a state it is connected to one end of the variable resistive element in the self-aligning manner. Therefore, the Schottky diode and the variable resistive element can be surely aligned to each other to be formed and the integration degree can be further improved. Since the metal film 26, the resistor 24 and the metal film 23 are aligned to each other by the self-aligning manner using the hard mask 27 as a mask, areas of the upper electrode of the variable resistive element, the resistor and the lower electrode can precisely coincide with each other in the current direction. As a result, the resistance value can be accurately controlled and, also, the integration degree is further improved. In addition, the metal film 23L, the variable resistive film 24L, the metal film 26L and the hard mask film 27L deposited in the peripheral region are removed by etching.

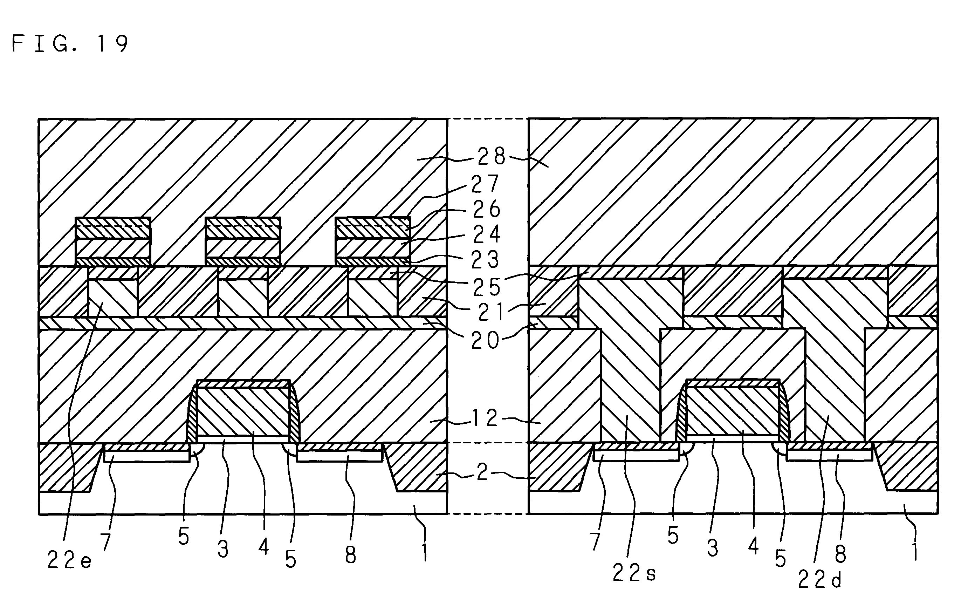

FIG. 19 is a schematic diagram showing a state where the surface is flattened before a wiring is formed. An insulating film 28 formed of a silicon oxide film, for example, is deposited as an interlayer insulating film and then flattened by the CMP method or the like.

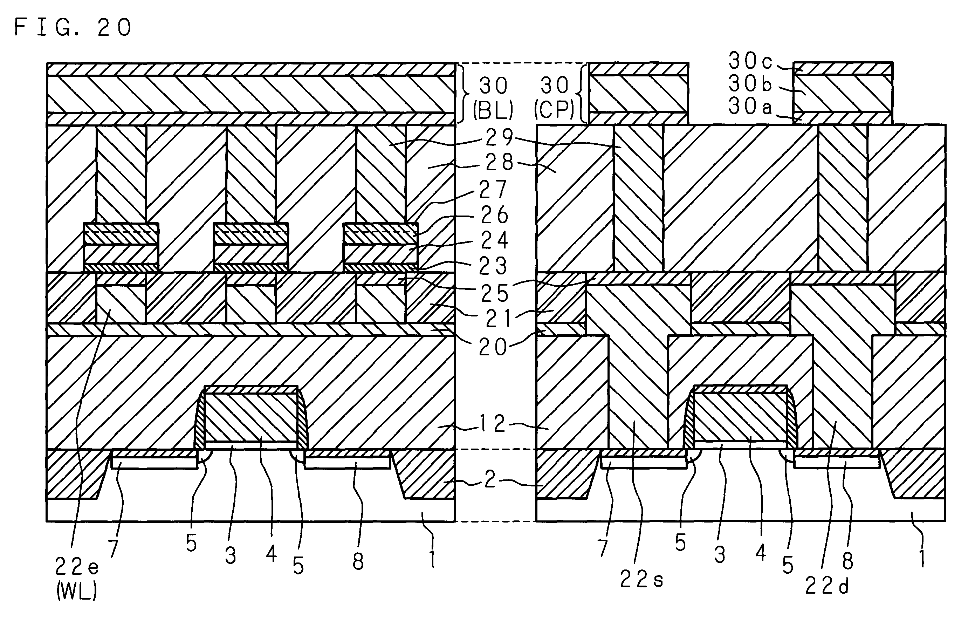

FIG. 20 is a schematic diagram showing a state where a wiring is formed. Openings (via holes) are formed in the insulating film 28 formed as shown in FIG. 19, corresponding to the metal film 26 (the hard mask 27) as the upper electrode of the variable resistive element, the source electrode 22s and the drain electrode 22d of the MOSFET. A tungsten plug 29 is formed by depositing tungsten in the openings. Then, a metal wiring film constituted by a three-layer film of TiN film 30a, AlCu film 30b and TiN film 30c, for example, is formed and patterned corresponding to a predetermined wiring pattern to form a metal wiring 30 so as to be appropriately connected to the tungsten plug 29.

As described above, the elements in the peripheral region and the elements in the memory region can be formed, respectively, without affecting each other. The metal wiring 30 (BL) and the polycrystalline silicon region 22e (WL) are formed as the bit line BL and the word line WL in the memory region, respectively. Then, the memory cell at the position where the word line WL and the bit line BL intersect with each other is selected and the writing, erasing and reading operations can be performed for it. In addition, since the metal wiring 30 (WP) is formed in the peripheral region as the circuit wiring, the signal processing required for the memory device can be performed.

As described above, since the memory cell of the present invention is constituted by the series circuit of the variable resistive element formed by using a variable resistive material in which a resistance value varies depending on application of a voltage, and the Schottky diode, an influence of a reading disturbance can be reduced. Also, the influence of the reading disturbance can be reduced in the memory device comprising such memory cells of the present invention.

Further, according to the present invention, since the first electrode of the Schottky diode is constituted by the impurity region of the semiconductor substrate or the polycrystalline silicon region selectively formed on the insulating film, an integration degree of the memory cell can be improved. In addition, since the variable resistive film is formed on the second electrode of the Schottky diode by the self-aligning manner, the resistance value of the variable resistive element can be accurately controlled and the memory device comprising such memory cells in which the integration degree is improved and the like can be realized.

Still further, according to the present invention, since the Schottky diode is constituted by the Schottky barrier between the metal silicide film and silicon, reduction of the forward threshold value of the diode can be easily realized and the stable diode characteristics can be obtained.

Yet further, according to the present invention, since the Schottky diode is formed and the crystalline property of the variable resistive film is improved at the same time by the single heat treatment, the number of heat treatments can be reduced. Thus, the manufacturing method of the memory cell, which has less affect in the peripheral circuits is realized and the integration degree of the peripheral circuit can be improved. In addition, since the variable resistive film is formed by two separate deposition processes, it is realized that the manufacturing method of the memory cell in which the characteristics (resistance value) of the Schottky diode and the crystalline property of the variable resistive film can be further improved.

## Claims

1. A memory cell comprising a variable resistive element and a current control element controlling a current flowing in said variable resistive element, **characterized in that** said current control element is a Schottky diode (32).

2. The memory cell as set forth in claim 1, **characterized in that** said variable resistive element (31) is formed of a resistive material having a perovskite-type crystalline structure.

3. The memory cell as set forth in claim 1 or 2, **characterized in that** a first electrode of said Schottky diode (32) is a second conductive type impurity region (10) formed on a first conductive type semiconductor substrate (1), and a second electrode of the same is a metal film (14) deposited on said impurity region (10).

4. The memory cell as set forth in claim 3, **characterized in that**
said semiconductor substrate (1) is a silicon substrate, and
said Schottky diode (32) has a Schottky barrier between said impurity region (10) and a metal silicide film (16) formed between said impurity region (10) and said metal film (14).

5. The memory cell as set forth in claim 3 or 4, **characterized in that** said impurity region (10) is selectively formed in an element isolation region (2) formed in said semiconductor substrate (1).

6. The memory cell as set forth in any one of claims 3 through 5, **characterized in that** a variable resistive film (15L) constituting said variable resistive element (31) is deposited on said second electrode of said Schottky diode (32) by a self-aligning manner.

7. The memory cell as set forth in claim 1 or 2, **characterized in that** a first electrode of said Schottky diode (32) is a polycrystalline silicon region (22e) selectively formed in said insulating film (21), and a second electrode of the same is a metal film (23L) deposited on said polycrystalline silicon region (22e).

8. The memory cell as set forth in claim 7, **characterized in that** said Schottky diode (32) has a Schottky barrier between said polycrystalline silicon region (22e) and a metal silicide film (25) formed between said polycrystalline silicon region (22e) and said metal film (23L).

9. A memory device in which memory cells are located at positions where word lines and bit lines arranged in a matrix intersect with each other, **characterized in that**
said memory cell (33) is constituted by a series circuit including a variable resistive element (31) and a Schottky diode (32) controlling a current flowing in said variable resistive element (31), and
one end of said series circuit is connected to said word line (WL), and other end of the same is connected to said bit line (BL), respectively.

10. The memory device as set forth in claim 9, **characterized in that** said variable resistive element (31) is formed of a resistive material having a perovskite-type crystalline structure.

11. The memory device as set forth in claim 9 or 10,
**characterized in that**
a first electrode of said Schottky diode (32) is connected to said word line (WL),
a second electrode of said Schottky diode (32) is connected to one end of said variable resistive element (31), and
said other end of said variable resistive element (31) is connected to said bit line (BL).

12. The memory device as set forth in any one of claims 9 through 11, **characterized in that** said word line (WL) is constituted by an impurity region (10) selectively formed in an element isolation region (2) formed in said semiconductor substrate (1).

13. The memory device as set forth in claim 12,
**characterized in that** said first electrode of said Schottky diode (32) is said impurity region (10), and a second electrode of the same is a metal film (14) deposited on said impurity region (10).

14. The memory device as set forth in claim 13,
**characterized in that**
said semiconductor substrate (1) is a silicon substrate, and
said Schottky diode (32) has a Schottky barrier between said impurity region (10) and a metal silicide film (16) formed between said impurity region (10) and said metal film (14).

15. The memory device as set forth in claim 13 or 14,
**characterized in that** a variable resistive film (15L) constituting said variable resistive element (31) is deposited on said second electrode of said Schottky diode (32) by a self-aligning manner.

16. The memory device as set forth in any one of claims 9 through 11, **characterized in that** said word line (WL) is constituted by a polycrystalline silicon region (22e) selectively formed in an insulating film (21).

17. The memory device as set forth in claim 16,
**characterized in that** said first electrode of said Schottky diode (32) is said polycrystalline silicon region (22e), and said second electrode of the same is a metal film (23L) deposited on said polycrystalline silicon region (22e).

18. The memory device as set forth in claim 17,
**characterized in that** said Schottky diode (32) has a Schottky barrier between said polycrystalline silicon region (22e) and a metal silicide film (25) formed between said polycrystalline silicon region (22e) and said metal film (23L).

19. A manufacturing method of forming a memory cell constituted by a series circuit of a variable resistive element and a Schottky diode, on a semiconductor substrate, **characterized by** comprising steps of
forming an insulating film (12) having openings (12w) on which impurity regions (10) formed on one surface of said semiconductor substrate (1) are exposed;
depositing a metal film (14) constituting an electrode of said variable resistive element (31) in said openings (12w) of said insulating film (12);
depositing a variable resistive film (15L) constituting a resistor (15) of said variable resistive element (31) on said metal film (14); and
forming a Schottky diode (32) by forming a metal silicide film (16) between said impurity region (10) and said metal film (14) by a heat treatment.

20. The manufacturing method as set forth in claim 19,
**characterized in that** said variable resistive film (15L) is deposited on said metal film (14) in said opening (12w) by a self-aligning manner.

21. The manufacturing method as set forth in claim 19 or 20,
**characterized in that** a temperature of said heat treatment is a temperature capable of improving a crystalline property of said variable resistive film (15L).

22. The manufacturing method as set forth in any one of claims 19 through 21, **characterized in that**
said semiconductor substrate (1) is a silicon substrate, and
said Schottky diode (32) has a Schottky barrier between said metal silicide film (16) and said impurity region (10).

23. A manufacturing method of forming a memory cell constituted by a series circuit of a variable resistive element and a Schottky diode, on a semiconductor substrate, **characterized by** comprising steps of:
forming an insulating film (12) having openings (12w) on which impurity regions (10) formed on one surface of said semiconductor substrate (1) are exposed;
depositing a metal film (14) constituting an electrode of said variable resistive element (31) in said openings (12w) of said insulating film (12);
depositing a variable resistive film (15a) having a first film thickness and constituting a resistor (15) of said variable resistive element (31) on said metal film (14);
forming a Schottky diode (32) by forming a metal silicide film (16) between said impurity region (10) and said metal film (14) by a heat treatment, and
depositing a variable resistive film (15b) having a second film thickness and constituting said resistor (15) on said variable resistive film (15a) having said first film thickness.

24. The manufacturing method as set forth in claim 23,
**characterized in that** a temperature of said heat treatment is a temperature capable of improving a crystalline property of said variable resistive film (15a) having said first film thickness.

25. The manufacturing method as set forth claim 23 or 24,
**characterized in that**
said semiconductor substrate (1) is a silicon substrate, and
said Schottky diode (32) has a Schottky barrier between said metal silicide film (16) and said impurity region (10).

26. The manufacturing method as set forth in any one of claims 23 through 25, **characterized by** further comprising a step of further performing a heat treatment after deposition of said variable resistive film (15b) having said second film thickness,
wherein a temperature of said heat treatment is a temperature capable of improving a crystalline property of said variable resistive film (15b) having said second film thickness and capable of reducing a resistance value of said metal silicide film (16).

27. A manufacturing method of forming a memory cell constituted by a series circuit of a variable resistive element and a Schottky diode, on a semiconductor substrate, **characterized by** comprising steps of:
selectively forming a polycrystalline silicon region (22e) in an insulating film (21) formed on one surface of said semiconductor substrate (1);
depositing a metal film (23L) constituting an electrode of said variable resistive element (31) on said polycrystalline silicon region (22e);
depositing a variable resistive film (24L) constituting a resistor (24) of said variable resistive element (31) on said metal film (23L); and
forming a Schottky diode (32) by forming a metal silicide film (25) between said polycrystalline silicon region (22e) and said metal film (23L) by a heat treatment.

28. The manufacturing method as set forth in claim 27,
**characterized in that** a temperature of said heat treatment is a temperature capable of improving a crystalline property of said variable resistive film (24L).

29. The manufacturing method as set forth claim 27 or 28,
**characterized in that** said Schottky diode (32) has a Schottky barrier between said metal silicide film (25) and said polycrystalline silicon region (22e).

30. A manufacturing method of forming a memory cell constituted by a series circuit of a variable resistive element and a Schottky diode, on a semiconductor substrate, **characterized by** comprising steps of:
selectively forming a polycrystalline silicon region (22e) in an insulating film (21) formed on one surface of said semiconductor substrate (1);
depositing a metal film (23L) constituting an electrode of said variable resistive element (31) on said polycrystalline silicon region (22e);
depositing a variable resistive film (24a) having a first film thickness and constituting a resistor (24) of said variable resistive element (31) on said metal film (23L);
forming a Schottky diode (32) by forming a metal silicide film (25) between said polycrystalline silicon region (22e) and said metal film (23L) by a heat treatment; and
depositing a variable resistive film (24b) having a second film thickness and constituting said resistor (24) on said variable resistive film (24a) having said first film thickness.

31. The manufacturing method as set forth in claim 30.
**characterized in that** a temperature of said heat treatment is a temperature capable of improving a crystalline property of said variable resistive film (24a) having said first film thickness.

32. The manufacturing method as set forth claim 30 or 31,
**characterized in that** said Schottky diode (32) has a Schottky barrier between said metal silicide film (25) and said polycrystalline silicon region (22e).

33. The manufacturing method as set forth in any one of claims 30 through 32, **characterized by** further comprising a step of further performing a heat treatment after deposition of said variable resistive film (24b) having said second film thickness,
wherein a temperature of said heat treatment is a temperature capable of improving a crystalline property of said variable resistive film (24b) having said second film thickness and capable of reducing a resistance value of said metal silicide film (25).

34. The manufacturing method as set forth in any one of claims 19 through 33, **characterized in that** said metal film (23L) is formed of a refractory metal material.

35. The manufacturing method as set forth in claim 34,
**characterized in that** said refractory metal material is selected from at least one of Pt, Ti, Co and Ni.
